# EUROPEAN PATENT SPECIFICATION

(11) **EP 1 999 992 B1**
(45) Date of publication and mention of the grant of the patent: **18.01.2012**
(21) Application number: 06808943.2
(22) Date of filing: 28.09.2006
(51) Int. Cl.: H04R 3/04, H03G 3/16, H03G 5/00

(54) **ADAPTIVE SPEAKER EQUALIZATION**
ADAPTIVE ENTZERRUNG FUER LAUTSPRECHER
ÉGALISATION DE HAUT-PARLEUR ADAPTABLE

(30) Priority: 24.03.2006 US 387836
(43) Date of publication of application: 10.12.2008
(73) Proprietor: Sony Ericsson Mobile Communications AB, 221 83 Lund (SE)
(72) Inventor: STENMARK, Frederik, Martin, S-21152 Malmo (SE); HOVMALM, Claes, S-266 57 Lund (SE)
(74) Representative: VALEA AB
(86) International application number: PCT/IB2006/002760
(87) International publication number: WO 2007/110693

(56) References cited:
- WO-A-97/38488
- US-A- 5 677 987
- US-A1- 2003 108 209
- US-A1- 2004 017 921

## Description

### BACKGROUND OF THE INVENTION

### Technical Field of the Invention

Implementations described herein relate generally to audio output devices, and more particularly, to speakers used in handheld devices.

### Description of Related Art

Devices, such as mobile communication devices, may be used by individuals in a variety of settings due to the portability of these devices. For example, an individual may receive a call while in his/her automobile and the individual may continue with the call while exiting the vehicle and walking down a noisy city street. When this individual received the call, the individual may have been in an environment with low background noise, e.g, the passenger compartment of a stationary automobile; however, as the call progressed, the individual may have entered a high background noise environment, e.g, the crowded city street.

An individual may have to make adjustments to a mobile communications device while engaged in a call if background noise levels change, e.g., goes from a low level to a high level, or vice versa. For example, an individual may increase the volume for a speaker in order to hear what the party on the other end of a call is saying when the individual is engaged in a call in a high background noise environment. An individual may also force a portion of a mobile device housing a speaker against his/her ear with greater force when engaged in a call in a high background noise environment. When an individual forces a portion of a mobile device against his/her ear, the acoustic characteristics of the speaker may change. For example, forcing an ear piece on a mobile device against one's ear may cause low frequency portions of a frequency response for a speaker located in the ear piece to change. As a result, sound coming out of the speaker may take on undesirable characteristics, e.g., a low frequency portion of the speaker output may have an amplitude that is higher than desired, resulting in too much bass in the speaker output.

An individual may not be satisfied with the sound quality of mobile communications devices when the frequency response of a speaker causes portions of a spectrum, such as low frequency portions of the spectrum, for the speaker to be unexpectedly amplified or attenuated in response to actions performed by the individual during a call.

US Patent Application Publication mo. 2003/0108209 concerns a communication device that includes an earpiece, a sensor, and an active equalization circuit. The earpiece transmits an acoustic output signal from the communication device. The sensor is proximately located with the earpiece and measures an acoustic pressure at the earpiece and generates a response signal. The active equalization circuit is coupled to the sensor and equalizes the acoustic output signal using the response signal.

### BRIEF SUMMARY OF THE INVENTION

According to one aspect, a device having the features recited in claim 1 is provided.

According to another aspect, a method having the steps recited in claim 4 is provided.

According to yet another aspect, a computer readable medium having the features recited in claim 11 that stores instructions executable by a processing device is provided.

Further embodiments of the invention are disclosed in the dependent claims.

### BRIEF DESCRIPTION OF THE DRAWINGS

The accompanying drawings, which are incorporated in and constitute a part of this specification, illustrate an embodiment of the invention and, together with the description, explain the invention. In the drawings,
Fig. I is a diagram of an exemplary implementation of a mobile terminal consistent with the principles of the invention;
Fig. 2 illustrates an exemplary functional diagram of a mobile terminal consistent with the principles of the invention;
Fig. 3 illustrates an exemplary functional diagram of the processing logic of Fig. 2 consistent with the principles of the invention;
Fig. 4 illustrates an exemplary data structure consistent with the principles of the invention;
Figs. 5A-D illustrate exemplary relationships between a mobile terminal and a user consistent with the principles of the invention;
Figs 6A-C illustrate exemplary frequency response curves that can be used with exemplary speaker implementations consistent with the principles of the invention; and
Fig. 7 is a flowchart of an exemplary method consistent with the principles of the invention.

### DETAILED DESCRIPTION OF THE INVENTION

The following detailed description of the invention refers to the accompanying drawings. The same reference numbers in different drawings may identify the same or similar elements. Also, the following detailed description does not limit the invention.

Implementations of the invention can be used to improve the characteristics of sound coming from a speaker in a device, such as a communications device. Implementations of the invention may adapt characteristics of the speaker output based on user selections or based on the detection of parameters, such as background noise levels. Implementations may alter portions of a frequency response curve for the speaker based on the user selections or detected background noise levels. For example, an implementation may increase or decrease the amplitude of certain frequencies within a frequency response curve based on a state of the device.

Exemplary implementations of the invention will be described in the context of a mobile communications terminal. It should be understood that a mobile communication terminal is an example of a device that can employ adaptive speaker equalization consistent with the principles of the invention and should not be construed as limiting the types or sizes of devices or applications that can use implementations of adaptive speaker equalization described herein.

### EXEMPLARY MOBILE TERMINAL

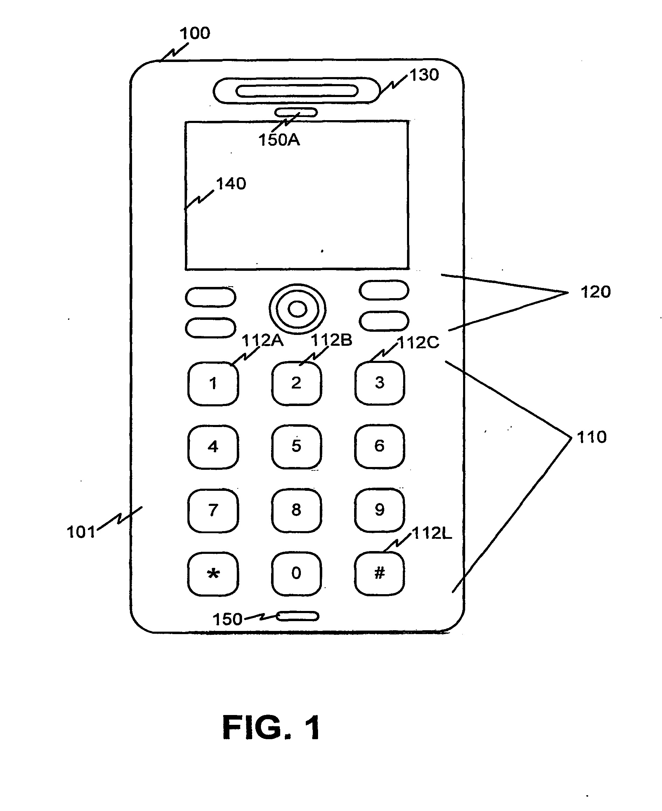

Fig. 1 is a diagram of an exemplary implementation of a mobile terminal consistent with the principles of the invention. Mobile terminal 100 (hereinafter terminal 100) may be a mobile communication device. As used herein, a "mobile communication device" and/or "mobile terminal" may include a radiotelephone; a personal communications system (PCS) terminal that may combine a cellular radiotelephone with data processing, a facsimile, and data communications capabilities; a personal digital assistant (PDA) that can include a radiotelephone, pager, Internet/intranet access, web browser, organizer, calendar, and/or global positioning system (GPS) receiver; and a laptop and/or palmtop receiver or other appliance that includes a radiotelephone transceiver.

Terminal 100 may include housing 101, keypad 110, control keys 120, speaker 130, display 140, and microphones 150 and 150A. Housing 101 may include a structure configured to hold devices and components used in terminal 100. For example, housing 101 may be formed from plastic and configured to support keys 112A-L (collectively keys 112), control keys 120, speaker 130, display 140 and microphone 150 or 150A. Housing 101 may have a first side, a second side, a third side, a fourth side, upper surface, and a lower surface (not shown). In one implementation, first side may correspond to a right side of terminal 100, second side may correspond to a lower side of terminal 100, third side may correspond to a left side of terminal 100 and fourth side may correspond to an upper side of terminal 100. Upper surface may support speaker 130, microphones 150 and 150A and other components of terminal 100.

Keypad 110 may include devices, such as keys 112A-L, that can be used to enter information into terminal 100. Keys 112 may be used in a keypad (as shown in Fig. 1), in a keyboard, or in some other arrangement of keys. Implementations of keys 112 may have key information associated therewith, such as numbers, letters, symbols, etc. A user may interact with keys 112 to input key information into terminal 100. For example, a user may operate keys 112 to enter digits, commands, and/or text, into terminal 100.

Control keys 120 may include buttons that permit a user to interact with terminal 100 to cause terminal 100 to perform an action, such as to display a text message via display 140, raise or lower a volume setting for speaker 130, etc. Speaker 130 may include a device that provides audible information to a user of terminal 100. Speaker 130 may be located in an upper portion of terminal 100 proximate to fourth side 105 and may function as an ear piece when a user is engaged in a communication session using terminal 100.

Display 140 may include a device that provides visual information to a user. For example, display 140 may provide information regarding incoming or outgoing calls, text messages, games, phone books, the current date/time, volume settings, etc., to a user of terminal 100. Microphones 150 and/or 150A may, respectively, include a device that converts speech or other acoustic signals into electrical signals for use by terminal 100. Microphone 150 may be located proximate to a lower side of terminal 100 (e.g., proximate to second side 103) and may be configured to convert spoken words or phrases into electrical signals for use by terminal 100. Microphone 150A may be located proximate to speaker 130 and may be configured to receive acoustic signals proximate to a user's ear while the user is engaged in a communications session using terminal 100. For example, microphone 150A may be configured to receive background noise and/or sound coming from speaker 130.

### EXEMPLARY FUNCTIONAL DIAGRAM

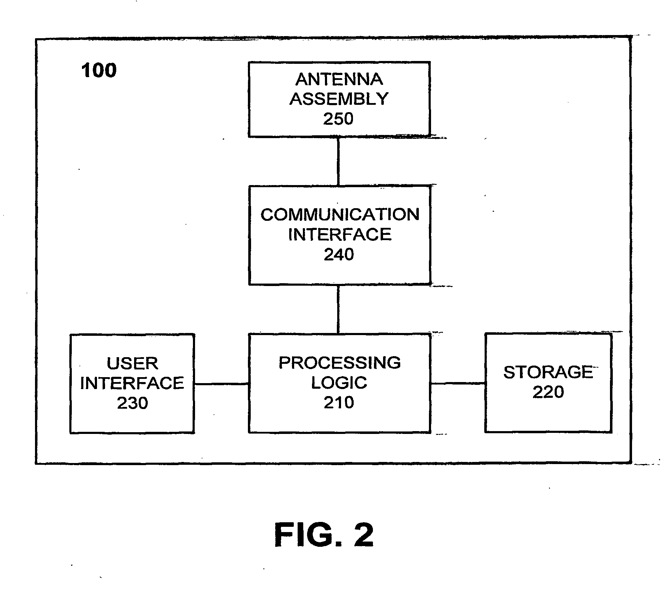

Fig. 2 illustrates an exemplary functional diagram of a mobile terminal consistent with the principles of the invention. As shown in Fig. 2, terminal 100 may include processing logic 210, storage logic 220, user interface 230, communication interface 240, and antenna assembly 250. Processing logic 210 may include a processor, microprocessor, an application specific integrated circuit (ASIC), field programmable gate array (FPGA), or the like. Processing logic 210 may include data structures or software programs to control operation of terminal 100 and its components. Storage logic 220 may include a random access memory (RAM), a read only memory (ROM), and/or another type of memory to store data and instructions that may be used by processing logic 210.

User interface 230 may include mechanisms for inputting information to terminal 100 and/or for outputting information from terminal 100. Examples of input and output mechanisms might include a speaker (e.g., speaker 130) to receive electrical signals and output audio signals, a microphone (e.g., microphone 150 or 150A) to receive audio signals and output electrical signals, buttons (e.g., control keys 120 and/or keys 112) to permit data and control commands to be input into terminal 100, a display (e.g., display 140) to output visual information, and/or a vibrator to cause terminal 100 to vibrate.

Communication interface 240 may include, for example, a transmitter that may convert base band signals from processing logic 210 to radio frequency (RF) signals and/or a receiver that may convert RF signals to base band signals. Alternatively, communication interface 240 may include a transceiver to perform functions of both a transmitter and a receiver. Communication interface 240 may connect to antenna assembly 250 for transmission and reception of the RF signals. Antenna assembly 250 may include one or more antennas to transmit and receive RF signals over the air. Antenna assembly 250 may receive RF signals from communication interface 240 and transmit them over the air and receive RF signals over the air and provide them to communication interface 240.

As will be described in detail below, terminal 100, consistent with the principles of the invention, may perform certain operations relating to adaptively equalizing the response of a speaker. Terminal 100 may perform these operations in response to processing logic 210 executing software instructions of a speaker equalization application contained in a computer-readable medium, such as storage 220. A computer-readable medium may be defined as a physical or logical memory device and/or carrier wave.

The software instructions may be read into storage logic 220 from another computer-readable medium or from another device via communication interface 240. The software instructions contained in storage 220 may cause processing logic 210 to perform processes that will be described later. Alternatively, hardwired circuitry may be used in place of or in combination with software instructions to implement processes consistent with the principles of the invention. Thus, implementations consistent with the principles of the invention are not limited to any specific combination of hardware circuitry and software.

### EXEMPLARY PROCESSING LOGIC FUNCTIONAL DIAGRAM

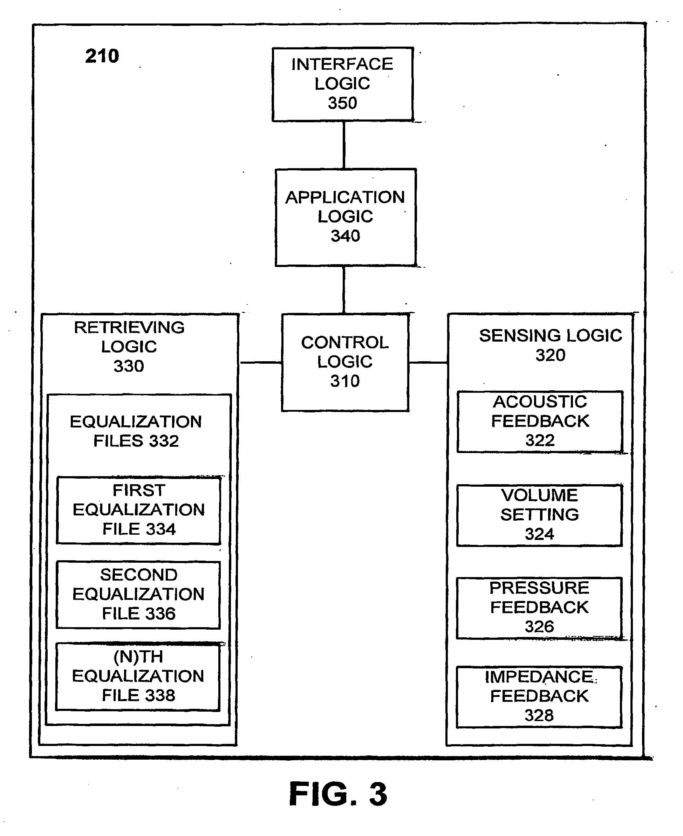

Fig. 3 illustrates an exemplary functional diagram of the processing logic of Fig. 2 consistent with the principles of the invention. Processing logic 210 may include control logic 310, sensing logic 320, retrieving logic 330, application logic 340 and interface logic 350.

Control logic 310 may include logic that controls the operation of terminal 100 and processes involved in operating terminal 100. Control logic 310 may be implemented in hardware or software based logic.

Sensing logic 320 may include logic used to obtain information on behalf of terminal 100. For example, an implementation of sensing logic 320 may include acoustic feedback logic 322, volume setting logic 324, pressure feedback logic 326, and impedance feedback logic 328. Acoustic feedback logic 322 may receive an input from microphone 150A. For example, microphone 150A may provide an electrical signal that is proportional to a background noise level proximate to speaker 130 and a user's ear. Acoustic feedback logic 322 may receive the signal from microphone 150A and may provide the signal to control logic 310 for processing.

Volume setting logic 324 may include logic to establish a volume setting for speaker 130. For example, a user may depress a control key 120 to increase or decrease a volume setting for speaker 130. Volume setting logic 324 may receive a signal from the control key 120 and may raise or lower a volume setting for speaker 130 alone or in conjunction with control logic 310. Volume setting logic 324 may be configured to receive signals on behalf of a user or may be configured to automatically adjust volume settings for speaker 130 based on signals received from other components operating in terminal 100, such as acoustic feedback logic 322, pressure feedback logic 326, etc.

Pressure feedback logic 326 may include logic to measure a force exerted on a portion of terminal 100. For example, an implementation of pressure feedback logic 326 may include a strain gauge or pressure sensor that generates an output based on a force proximate to the pressure sensor and/or speaker 130. Assume that a user presses terminal 100 against his/her ear with a first force when speaking in an empty function hall. Further assume that the user presses terminal 100 against his/her ear with a second force that is greater than the first force when the function hall is full of people. Pressure feedback logic 326 may sense the first pressure or the second pressure and may change characteristics of speaker 130 based on an output of pressure feedback logic 326. For example, a volume setting of speaker 130 may be increased and/or a frequency response for speaker 130 may be changed in response to the second pressure since the second pressure may be associated with a user that is pressing an ear piece against his/her ear in order to hear sound coming from speaker 130 when using terminal 100 in a high background noise environments.

Impedance feedback logic 328 may include logic that monitors an acoustic, mechanical, or electrical impedance of a component in terminal 100, such as an impedance of speaker 130. For example, speaker 130 may have a first impedance when the user applies the first force to terminal 100 while using terminal 100 in the empty function hall, and speaker 130 may have a second impedance when the user applies the second force to terminal 100 while using terminal 100 in the crowded function hall. Impedance feedback logic 328 may measure the first impedance or the second impedance and may provide a signal to control logic 310 that is used to change one or more characteristics of speaker 130. For example, control logic 310 may retrieve an equalization file or may generate an equalization file for use in driving speaker 130 in a manner that produces a desired frequency response for speaker 130 based on a configuration of terminal 100.

Retrieving logic 330 may include logic to retrieve one or more equalization files 332 that can be used to modify a frequency response for speaker 130 based on usage configurations of terminal 100. Retrieving logic 330 may operate with one or more equalization files 332, such as first equalization file 334, second equalization file 336, and nth equalization file 338. Equalization files 332 may include equalization instructions that are configured to change a frequency response for speaker 130 when applied to an input of speaker 130.

Assume that first equalization file 334 includes instructions to modify the frequency response for speaker 130 when a user is pressing terminal 100 against his/her ear with light pressure, such as would be used when the user is engaged in a call in a quiet room, and second equalization file 336 includes instructions that can be used to modify the frequency response of speaker 130 when the user is firmly pressing terminal 100 against his/her ear, such as when the user is engaged in a call in a noisy room. Further assume that nth equalization file 338 may be used to modify a frequency response of speaker 130 when the use is using terminal 100 in another operating environment, such as operating terminal 100 outdoors when a strong wind is blowing and creating wind noise proximate to speaker 130 and the user's ear.

Implementations of equalization files 332 may be of a certain format, such as an audio parameter file format that may be identified using a file designation, or extension, such as ".asp". Audio parameter files may include machine-readable instructions configured to change a frequency response for speaker 130. For example, information in an audio parameter file may be applied to an input signal of speaker 130. The combined input signal and audio parameter file information may operate to produce a desired frequency response at an output of speaker 130.

Application logic 340 may include logic that applies equalization files 332 to speaker 130 in cooperation with interface logic 350. For example, application logic 340 may convert information in equalization files 332 into a digital form that can be applied to digitized acoustic signals intended for speaker 130. In one implementation, terminal 100 may receive digitized acoustic signals via a wireless link. Processing logic 210 may receive these digitized acoustic signals from communication interface 240 and may apply one or more equalization files 332 to the digitized acoustic signals via application logic 340 to produce an equalized speaker input signal. Application logic 240 may provide the equalized speaker input signal to interface logic 350. Interface logic 350 may include logic to provide digitized acoustic signals and/or equalized speaker input signals to speaker 130 to produce sound having characteristics that are appealing to a user of terminal 100.

### EXEMPLARY DATA STRUCTURE

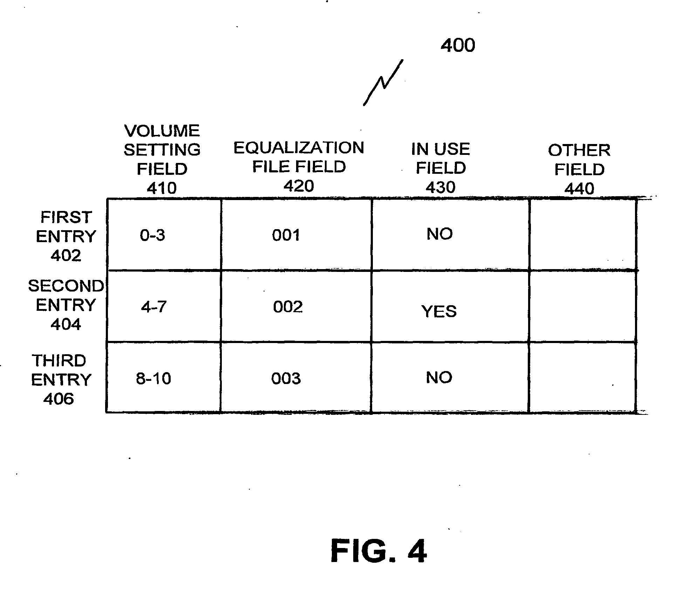

Fig. 4 illustrates an exemplary data structure consistent with the principles of the invention. Data structure 400 may include a computer-readable medium that can be used to store information in a machine-readable format. In an exemplary implementation, data structure 400 may be used to store information that is used to modify a frequency response for speaker 130 based on an operating characteristics of terminal 100 or based on a user input.

Data structure 400 may include information arranged in fields, such as volume setting field 410, equalization file field 420, in use field 430, and other field 440. Information in data structure 400 may be arranged in a row and column format to facilitate interpretation by a user of terminal 100. Entries 402-406 may be used to identify information associated with volume setting field 410, equalization file field 420, in use field 430, and other field 440.

Volume setting field 410 may include information that represents a volume setting that can be used with terminal 100. For example, terminal 100 may be configured to operate with volume settings having a range from zero to ten, with zero being the lowest volume setting and ten being a highest volume setting. Volume setting field 410 may include a single volume setting for an entry, such as 0, 1, 5, etc., or may include ranges of volume settings for respective entries in data structure 400, such as 0-3 for entry 402, 4-7 for entry 404, or 8-10 for entry 406.

Equalization file field 420 may include information that can be used to identify one or more equalization files 332 that can be used to modify a frequency response of speaker 130. In one implementation, equalization files 334, 336, 338 may each be identified with a range of volume settings. Equalization files 334-338 may have identifiers, such as numerical identifiers or alphanumeric identifiers, associated there with. For example, an equalization file that is used for a volume setting of 0-3 may be identified as equalization file 001. Equalization file 001 may correspond to first equalization file 334 in one implementation.

In use field 430 may include information that identifies whether an equalization file identified by equalization file field 420 is being used by terminal 100. For example, in use field 430 may include NO for entries 402 and 406 to indicate that the respective equalization files (i.e., equalization files having identifiers of 001 and 003, respectively) for those entries are not currently in use by terminal 100. In contrast, in use filed 430 for entry 404 may include YES to indicate that equalization file 002 is in use by terminal 100.

### EXEMPLARY USAGE CONFIGURATION

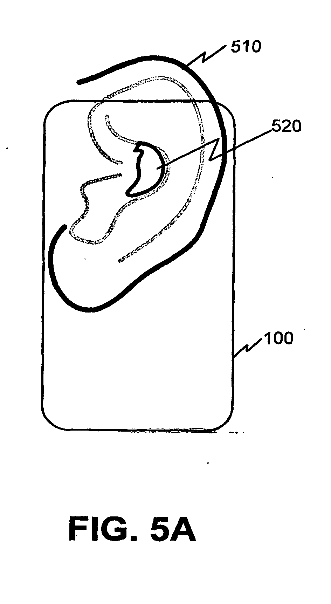

Figs. 5A-D illustrate exemplary relationships between a mobile terminal and a user consistent with the principles of the invention. Fig. 5A illustrates an exemplary relationship between a user and mobile terminal 100 when the user is engaged in a communication session using terminal 100. For example, Fig. 5A shows an outline of terminal 100 in relationship to a user's ear 510. In the exemplary configuration of Fig. 5A, speaker 130 may be arranged substantially in line with ear canal 520 so that sound from speaker 130 is conveyed into ear canal 520 in an unimpeded manner.

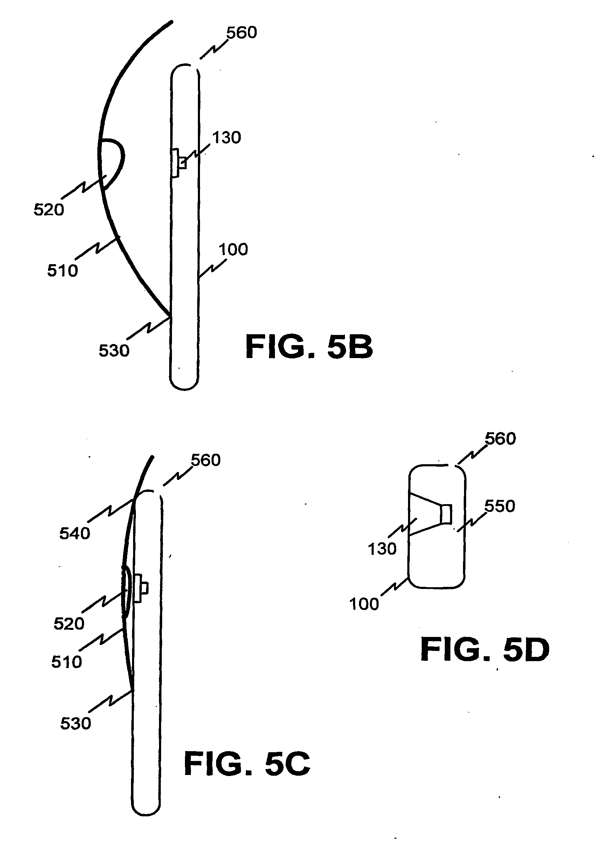

Fig. 5B illustrates a side view of the relationship of Fig. 5A. Fig. 5B may represent a configuration that is employed by a user when using terminal 100 in environments with low background noise, such as an empty room. Terminal 100 may be configured to provide sound from speaker 130 to ear canal 520 with a first frequency response that is selected to make sound quality satisfactory to a user. For example, the first frequency response may be selected so that bass, mid range, and high range frequencies are balanced in a way that allows the user to understand a party on the other end of a call. When a user employs the relationship of Fig. 5B, terminal 100 may contact the user's ear 510 at location 530.

Implementations of terminal 100 may be configured with a port 560 (also referred to as a vent) to allow pressure on a back side of speaker 130 (e.g. the portion of speaker facing an interior portion of terminal 100) to be equalized with a pressure on a front side of speaker 130 (e.g., the portion of speaker 130 that faces ear canal 520 in Fig. 5B). Fig. 5D illustrates port 560, speaker 130, and an interior volume 550 of terminal 100 in more detail. Terminal 100 may be configured to provide acoustic signals to ear canal 520 according to a determined frequency response when the pressure on the backside of speaker 130 is substantially equal to a pressure on a front side of speaker 130, such as the relationship of Fig. 5B. A frequency response used for speaker 130 in the relationship of Fig. 5B may be configured to account for leakage (i.e., acoustic signals passing through port 560 and entering ear canal 520 via the gap between ear 510 and the top of terminal 100 shown in Fig. 5B.

Fig. 5C illustrates an alternative relationship between a user and terminal 100. The relationship of Fig. 5C may represent a situation where a user is pressing terminal 100 against his/her ear with greater force as compared to a force between terminal 100 an a user's ear in Fig. 5B. A user may employ the relationship of Fig. 5C when engaged in a communication session in an environment with high background noise. The user may press terminal 100 against his/her ear in order to increase the signal-to-noise ratio (i.e., increase the volume of the desired signal coming out of speaker 130 with respect to a background noise level). When the user employs the relationship of Fig. 5C, an upper portion of terminal 100 may contact ear 510 at location 540 while a lower portion of terminal 100 contacts ear 510 at location 530. A seal may be formed between terminal 100 and a user's ear 510 when terminal 100 contacts the user's ear 510 at location 540 and 530. The seal may cause a pressure on a front side of speaker 130 to increase with respect to a pressure on a back side of speaker 130, thus changing the frequency response of speaker 130. The relationship of Fig. 5C may also reduce and/or eliminate leakage from port 560 to ear canal 520 around the upper portion of terminal 100. Reducing and/or eliminating leakage reaching ear canal 520 may further change the characteristics of sound entering ear canal 520 in Fig. 5C.

### EXEMPLARY SPEAKER CHARACTERISTICS

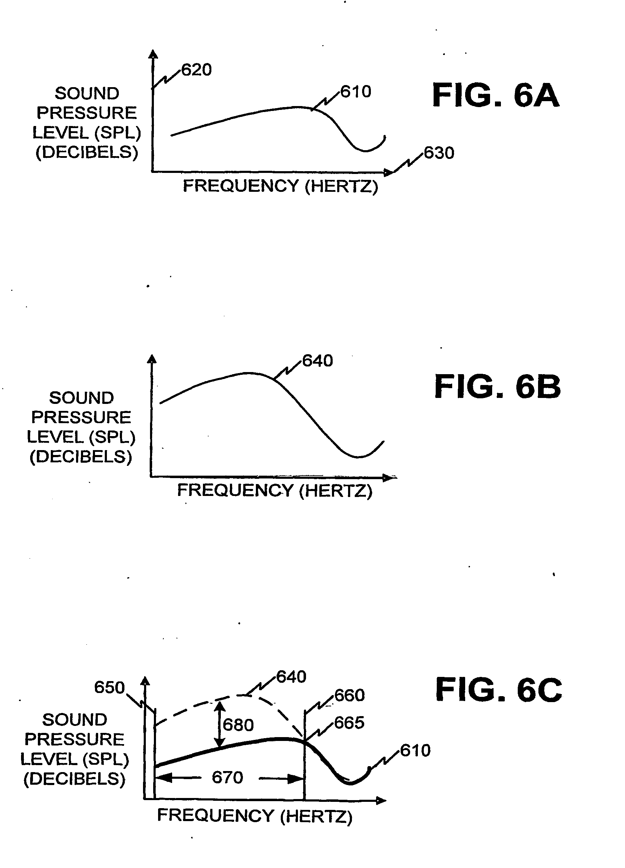

Figs 6A-C illustrate exemplary frequency response curves that can be used with exemplary speaker implementations consistent with the principles of the invention. Fig. 6A illustrates an exemplary frequency response curve 610 for speaker 130. Frequency response curve 610 may be represented along a y-axis 620 that represents a sound pressure level (SPL) that can have units of decibels (dB). Frequency response curve 610 may also be represented along an x-axis that represents a frequency that may have units of Hertz (Hz). Frequency response curve 610 may represent the output characteristics of speaker 130 for a particular configuration. For example, frequency response 610 may represent an output of speaker 130 for the relationship illustrated in Fig. 5B.

Fig. 6B illustrates a second exemplary frequency response curve 640 that may represent output characteristics of speaker 130 for a second configuration. For example, frequency response curve 640 may occur when a user presses terminal 100 against his/her ear with sufficient force so as to form a seal (e.g., the relationship illustrated in Fig. 5C). When frequency response curve 640 is present, a user may perceive sound coming from speaker 130 as having too much bass. As a result, sound coming from speaker 130 may have a boomy quality, thus making it difficult for the user to understand what a party on the other end of a call is saying.

Implementations of the invention may provide modified equalization signals to speaker 130 to produce desired frequency response curves for substantially any relationship between a user and terminal 100. For example, first equalization file 334 may be used to produce frequency response curve 610 for the relationship shown in Fig. 5B. If a user presses the phone to his/her ear as shown in Fig. 5C, first equalization file 334 may produce frequency response curve 640 if applied to speaker 130 when the relationship of Fig. 5C is present. An implementation of the invention may apply, for example, second equalization file 336 to speaker 130 when the relationship of Fig. 5C is present so that frequency response curve 610 is achieved.

Fig. 6C illustrates a relationship between frequency response curves 610 and 640. Implementations may provide equalization signals that take into account a relationship between a user and terminal 100. For example, implementations may determine a frequency band 670 over which corrective equalization may be made. Frequency band 670 may have a lower range 650 that may represent a lowest frequency over which a frequency response correction may be made. Frequency band 670 may further include an upper range 660 that may represent a highest frequency over which a frequency response correction may be made. In one implementation, upper range 660 may correspond with a cross over point 665, i.e. a frequency at which frequency response curves 610 and 640 intersect. Implementations may further determine an amplitude difference 680 between a desired frequency response curve (e.g., frequency response curve 610) and an undesirable frequency response curve that is caused by a relationship between a user and terminal 100 (e.g., frequency response curve 640). Amplitude difference 680 may be implemented as an average across frequency band 670 or may be done on a frequency by frequency basis. For example, amplitude difference 680 may be performed for each frequency making up band 670, e.g., frequencies at 100 Hz, 101Hz, etc.

Second equalization file 336 may include digital information for an equalization signal that represents a difference between frequency response curve 640 and frequency response curve 610 over frequency band 670. Second equalization file 336 may be applied to a drive signal for speaker 130 when the relationship of Fig. 5C is present so that frequency response curve 610 is produced at the output of speaker 130.

### EXEMPLARY METHOD

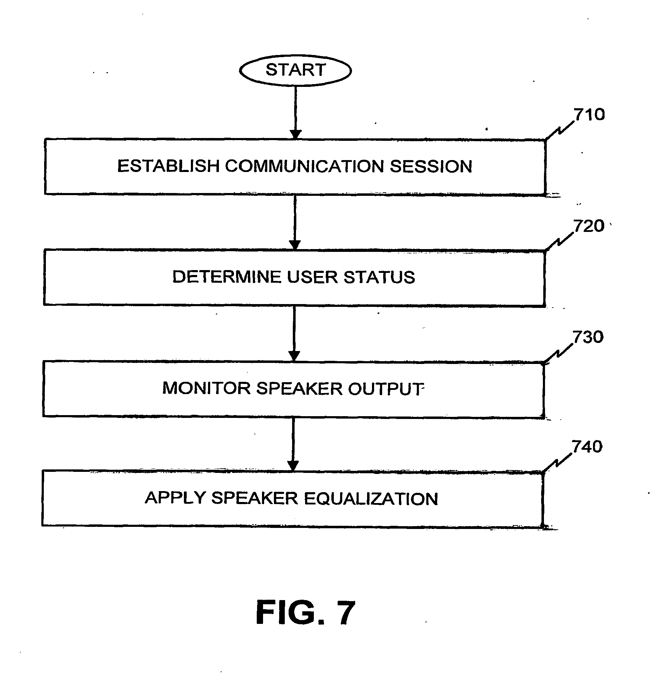

Fig. 7 is a flowchart of an exemplary method consistent with the principles of the invention. A communication session may be established between terminal 100 and another device (herein calling device), such as another mobile communications device or a landline telephone (act 710). A user of terminal 100 may speak into microphone 150 and may receive audio signals, such as speech associated with the calling party, via speaker 130 while participating in the communication session.

Terminal 100 may determine the status of the user (act 720). For example, mobile terminal 100 may determine whether the user is holding terminal 100 to his/her ear and/or whether the user is operating terminal 100 in another manner, such as using a speaker phone feature of terminal 100. When the user is operating terminal 100 proximate to his/her ear, acts 730 and 740 may be performed.

Terminal 100 may monitor the output of speaker 130 when the user is engaged in a communication session with terminal 100 proximate to his/her ear, such as the relationships of Figs. 5A-5C (act 730). For example, terminal 100 may monitor speaker 130 to determine whether the user is communicating with the calling party from a low background noise environment or a high background noise environment.

In one implementation, terminal 100 may monitor an output of speaker 130 by determining a volume setting in use on terminal 100. For example, terminal 100 may determine if the user has selected a volume setting of 0-3 (entry 402, Fig. 4), 4-7 (entry 404, Fig. 4) or 8-10 (entry 406, Fig. 4). A volume setting of 0-3 may identify the user as being in a low background noise environment, a volume setting of 4-7 may identify the user as being in a mid background noise environment, and a volume setting of 8-10 may identify the user as being in a high background noise environment.

In a second implementation, terminal 100 may monitor the output of speaker 130 using microphone 150A. Microphone 150A may receive acoustic signals from a front face of speaker 130, acoustic signals associated with leakage through port 560, and acoustic signals associated with background noise from the environment that the user is in while engaged in the communication session. When the user and terminal 100 are in the relationship of Fig. 5B, microphone 150A may receive background noise and leakage having first amplitudes, respectively. If the user and terminal 100 take on the relationship of Fig. 5C, microphone 150A may receive background noise and leakage having second amplitudes, respectively, that are lower than the respective first amplitudes. Processing logic 210 may process an output of microphone 150A and may determine when the relationship of Fig. 5C is present

In a third implementation, terminal 100 may monitor the output of speaker 130 using a pressure sensor proximate to speaker 130. For example, if the user and terminal 100 have the relationship of Fig. 5B, a first pressure may be exerted on the upper surface (Fig. 1) of terminal 100. When the relationship of Fig. 5C is present, a second pressure, that is greater than the first pressure, may be exerted on the upper surface. Processing logic 210 may receive an output signal from the pressure sensor for the relationships of Fig. 5B and Fig. 5C and may process the pressure sensor signals in accordance with aspects of the invention.

In a fourth implementation, terminal 100 may monitor output characteristics of speaker 130 by sensing an impedance of speaker 130. For example, impedance feedback logic 328 may monitor an electrical input impedance to speaker 130. An input impedance of speaker 130 may change as a function of an output frequency response for speaker 130. Assume that a user operates terminal 100 according to the relationship of Fig. 5B. Impedance feedback logic 328 may monitor a first impedance for speaker 130. Further assume that the user then presses terminal 100 against his/her ear as shown in the relationship of Fig. 5C. Impedance feedback logic 328 may monitor a second impedance for speaker 130 that is different than the first impedance for speaker 130. Control logic 310 may be configured to apply a new equalization file 332 to speaker 130 via application logic 340 when the second impedance is detected.

Speaker equalization may be applied based on a relationship between the user and terminal 100 (act 740). Control logic 310 may receive information from sensing logic 320 that is representative of an output of speaker 130. For example, control logic 310 may receive acoustic feedback information 322 via microphone 150A, volume setting information 324 via control keys 120, pressure feedback information 326 via a pressure sensor proximate to speaker 130, or impedance feedback information 328 via electrical or acoustical impedance detection components.

Control logic 310 may determine if a frequency response for speaker 130 has deviated from a desired frequency response or a range of frequency responses. Control logic 310 may use amplitude characteristics and/or spectral characteristics (e.g., frequency distortion) to determine if a frequency response for speaker 130 has deviated from a desired range. For example, a desired frequency response for speaker 130 may be represented by frequency response curve 610 (Fig. 6A). Control logic 310 may determine that speaker 130 has a frequency response similar to frequency response 640 (Fig. 6B) based on information from sensing logic 320. Control logic 310 may retrieve an equalization file 322 via retrieving logic 330. For example, retrieving logic 330 may provide control logic 310 with nth equalization file 338.

Nth equalization file 338 may be configured to produce frequency response curve 610 at an output of speaker 130 when nth equalization file 338 is applied to an input signal of speaker 130 when the relationship of Fig. 5C is present. For example, processing logic 210 may receive a signal from antenna assembly 250 and communication interface 240 that includes speech information from the calling party. This speech information may be in the form of a digital input signal that can be used as an input signal to speaker 130. Control logic 310 may provide nth equalization file 338 and the digital input signal to application logic 340. Application logic 340 may combine the digital input signal and nth equalization file 338 to produce an equalized input signal that is sent to speaker 130. The equalized input signal may be configured to produce frequency response curve 610 at an output of speaker 130 for a user and terminal 100 relationship, such as the user and terminal 100 relationship of Fig. 5C.

Terminal 100 may continue to monitor the output of speaker 130 and may remove nth equalization file 338 from the digital input signal via application logic 340 and/or may use additional equalization files 332, such as first equalization file 334 or second equalization file 336 to maintain a desired frequency response curve at an output of speaker 130.

### CONCLUSION

Implementations consistent with the principles of the invention may facilitate equalization of a frequency response for a speaker used in a handheld device. Implementations may monitor an output frequency response for a speaker and may apply equalization signals when the output frequency response deviates from a desired shape. Implementations, may apply substantially any number of equalization signals thus allowing terminal 100 to provide desired output frequency responses for the speaker for varying relationships between a user and terminal 100 and for varying environmental characteristics that the user and terminal 100 are operating in, such as high background noise environments.

The foregoing description of preferred embodiments of the invention provides illustration and description, but is not intended to be exhaustive or to limit the invention to the precise form disclosed. Modifications and variations are possible in light of the above teachings or may be acquired from practice of the invention.

While a series of acts has been described with regard to Fig. 7, the order of the acts may be modified in other implementations consistent with the principles of the invention. Further, non-dependent acts may be performed in parallel.

It will be apparent to one of ordinary skill in the art that aspects of the invention, as described above, may be implemented in many different forms of software, firmware, and hardware in the implementations illustrated in the figures. The actual software code or specialized control hardware used to implement aspects consistent with the principles of the invention is not limiting of the invention. Thus, the operation and behavior of the aspects were described without reference to the specific software code--it being understood that one of ordinary skill in the art would be able to design software and control hardware to implement the aspects based on the description herein.

It should be emphasized that the term "comprises/comprising" when used in this specification and/or claims is taken to specify the presence of stated features, integers, steps or components but does not preclude the presence or addition of one or more other feature, integers, steps, components or groups thereof.

No element, act, or instruction used in the present application should be construed as critical or essential to the invention unless explicitly described as such. Also, as used herein, the article "a" is intended to include one or more items. Where only one item is intended, the term "one" or similar language is used. Further, the phrase "based on" is intended to mean "based, at least in part, on" unless explicitly stated otherwise.

## Claims

1. A device (100), comprising:
a speaker (130), the device (100) **characterized by**:
logic (210) configured to:
detect a pressure exerted on the surface of the device (100) proximate to the speaker (130),
process the detected pressure,
load equalization logic based on the detected pressure, and
apply the equalization logic to an input signal to the speaker (130) when the detected pressure indicates that a frequency response for the speaker shoulb be changed.

2. The device (100) of claim 1, wherein the Equalization logic comprises an equalization file (332, 334, 336, 338) containing machine-readable instructions configured to modify the frequency response of the speaker (130).

3. The device (100) of claim 1, wherein the logic is further configured to:
detect a user input configured to change the condition of the speaker (130).

4. A method **characterized by**:
detecting a physical pressure exerted on the surface of a communication device (100) proximate to a speaker (130) in the communication device (100) during a communications session;
determining whether a portion of a frequency response for the speaker (130) is within a determined limit, based on the detected physical pressure,
retrieving an equalization signal from a memory in response to the determining ; and
applying the equalization signal to signals input to the speaker (130) to modify the portion of the frequency response when the portion of the frequency response is outside the determined limit.

5. The method of claim 4, wherein the determining further comprises:
determining if an amplitude for the portion of the frequency response is within or outside the determined limit.

6. The method of claim 4, wherein the determining further comprises:
determining if a spectral characteristic of the portion of the frequency response is within or outside the determined limit.

7. The method of claim 4, wherein the determining further comprises:
establishing a lower limit or an upper limit for a frequency band;
associating the portion of the frequency response with a range of frequencies above the lower limit or below the upper limit; and
determining if frequencies within the portion of the frequency response are within or outside the determined limit.

8. The method of claim 4, wherein the detecting further comprises:
detecting information about a relationship between a user and the communication device (100).

9. The method of claim 4, wherein the detecting further comprises:
detecting information about a first relationship between a user and the communication device (100), where the first relationship has a first frequency response therewith;
detecting information about a second relationship between the user and the communication device (100), where the second relationship has a second frequency response that differs from the first frequency response; and
providing the information about the first relationship or the second relationship to the determining; and
wherein the determining further comprises:
determining whether the first frequency response or the second frequency response is within or outside the determined limit.

10. The method of claim 4, further comprising:
monitoring the speaker (130) after applying the equalization signal to determine if the frequency response is within the determined limit.

11. A computer readable medium that stores instructions executable by a processing device, the computer readable medium comprising:
instructions to detect a physical pressure exerted on the surface of a communication device proximate to a speaker;
instructions to determine when a frequency response for the speaker is outside a preferred range, based on the detected physical pressure;
instructions to identify an equalization instruction configured to produce an adjusted frequency response that is within the preferred range when applied to an input signal of the speaker that is present when the frequency response is outside the preferred range;
instructions to apply the identified equalization instruction to the input signal to produce an equalized input signal; and
instructions to determine whether the frequency response is outside the preferred range when the equalized input signal is applied.

## Patentansprüche

1. Vorrichtung (100), umfassend:
einen Lautsprecher (130), wobei die Vorrichtung (100) **gekennzeichnet ist durch**:
eine Logik (210), welche ausgestaltet ist,
einen Druck zu erfassen, welcher auf die Fläche der Vorrichtung (100) benachbart zu dem Lautsprecher (130) ausgeübt wird,
den erfassten Druck zu verarbeiten,
eine Entzerrungslogik auf der Grundlage des erfassten Drucks zu laden, und
die Entzerrungslogik auf ein Eingangssignal für den Lautsprecher (130) anzuwenden, wenn der erfasste Druck anzeigt, dass eine Frequenzantwort für den Lautsprecher geändert werden sollte.

2. Vorrichtung (100) nach Anspruch 1, wobei die Entzerrungslogik eine Entzerrungsdatei (332, 334, 336, 338) umfasst, welche maschinenlesbare Anweisungen enthält, welche ausgestaltet sind, die Frequenzantwort des Lautsprechers (130) zu verändern.

3. Vorrichtung (100) nach Anspruch 1, wobei die Logik ferner ausgestaltet ist, eine Benutzereingabe zu erfassen, welche ausgestaltet ist, den Zustand des Lautsprechers (130) zu ändern.

4. Verfahren, **gekennzeichnet durch**:
Erfassen eines physikalischen Drucks, welcher auf die Fläche einer Kommunikationsvorrichtung (100) benachbart zu einem Lautsprecher (130) in der Kommunikationsvorrichtung (100) während einer Kommunikationssitzung ausgeübt wird;
Bestimmen auf der Grundlage des erfassten physikalischen Drucks, ob ein Abschnitt einer Frequenzantwort für den Lautsprecher (130) innerhalb einer bestimmten Grenze ist, Abfragen eines Entzerrungssignals von einem Speicher als Antwort auf das Bestimmen; und
Anwenden des Entzerrungssignals auf Signale, welche dem Lautsprecher (130) eingegeben werden, um den Abschnitt der Frequenzantwort zu verändern, wenn der Abschnitt der Frequenzantwort außerhalb der bestimmten Grenze ist.

5. Verfahren nach Anspruch 4, wobei das Bestimmen ferner umfasst:
Bestimmen, ob eine Amplitude für den Abschnitt der Frequenzantwort innerhalb oder außerhalb der bestimmten Grenze ist.

6. Verfahren nach Anspruch 4, wobei das Bestimmen ferner umfasst:
Bestimmen, ob eine spektrale Charakteristik des Abschnitts der Frequenzantwort innerhalb oder außerhalb der bestimmten Grenze ist.

7. Verfahren nach Anspruch 4, wobei das Bestimmen ferner umfasst:
Einrichten einer unteren Grenze oder einer oberen Grenze für ein Frequenzband;
in Verbindung Bringen des Abschnitts der Frequenzantwort mit einem Bereich von Frequenzen über der unteren Grenze oder unter der oberen Grenze; und
Bestimmen, ob Frequenzen innerhalb des Abschnitts der Frequenzantwort innerhalb oder außerhalb der bestimmten Grenze sind.

8. Verfahren nach Anspruch 4, wobei das Erfassen ferner umfasst:
Erfassen einer Information über eine Beziehung zwischen einem Benutzer und der Kommunikationsvorrichtung (100).

9. Verfahren nach Anspruch 4, wobei das Erfassen ferner umfasst:
Erfassen einer Information über eine erste Beziehung zwischen einem Benutzer und der Kommunikationsvorrichtung (100), wobei die erste Beziehung eine erste Frequenzantwort damit aufweist;
Erfassen einer Information über eine zweite Beziehung zwischen dem Benutzer und der Kommunikationsvorrichtung (100), wobei die zweite Beziehung eine zweite Frequenzantwort aufweist, welche sich von der ersten Frequenzantwort unterschiedet; und
Bereitstellen der Information über die erste Beziehung oder die zweite Beziehung für das Bestimmen; und
wobei das Bestimmen ferner umfasst:
Bestimmen, ob die erste Frequenzantwort oder die zweite Frequenzantwort innerhalb oder außerhalb der bestimmten Grenze ist.

10. Verfahren nach Anspruch 4, ferner umfassend:
Überwachen des Lautsprechers (130) nach einem Zuführen des Entzerrungssignals, um zu bestimmen, ob die Frequenzantwort innerhalb der bestimmten Grenze ist.

11. Computerlesbares Medium, welches Anweisungen speichert, welche von einer Verarbeitungsvorrichtung ausführbar sind, wobei das computerlesbare Medium umfasst:
Anweisungen, um einen physikalischen Druck zu erfassen, welcher auf die Fläche einer Kommunikationsvorrichtung benachbart zu einem Lautsprecher ausgeübt wird;
Anweisungen, um auf der Grundlage des erfassten physikalischen Drucks zu bestimmen, wenn eine Frequenzantwort für den Lautsprecher außerhalb eines bevorzugten Bereichs ist;
Anweisungen, um eine Entzerrungsanweisung zu identifizieren, welche ausgestaltet ist, eine angepasste Frequenzantwort zu erzeugen, welche innerhalb des bevorzugten Bereichs ist, wenn sie auf ein Eingangssignal des Lautsprechers angewendet wird, welches vorhanden ist, wenn die Frequenzantwort außerhalb des bevorzugten Bereichs ist;
Anweisungen, um die identifizierte Entzerrungsanweisung auf das Eingangssignal anzuwenden, um ein entzerrtes Eingangssignal zu erzeugen; und
Anweisungen, um zu bestimmen, ob die Frequenzantwort außerhalb des bevorzugten Bereichs ist, wenn das entzerrte Eingangssignal angewendet wird.

## Revendications

1. Dispositif (100), comprenant :
un haut-parleur (130), le dispositif (100) étant **caractérisé par** :
une logique (210), configurée de façon à :
détecter une pression exercée sur la surface du dispositif (100) à proximité du haut-parleur (130),
traiter la pression détectée,
charger une logique d'égalisation en fonction de la pression détectée, et
appliquer la logique d'égalisation à un signal d'entrée du haut-parleur (130) lorsque la pression détectée indique qu'une réponse en fréquence pour le haut-parleur devrait être changée.

2. Dispositif (100) selon la revendication 1, dans lequel la logique d'égalisation comprend un fichier d'égalisation (332, 334, 336, 338) contenant des instructions lisibles par une machine, configurées de façon à modifier la réponse en fréquence du haut-parleur (130).

3. Dispositif (100) selon la revendication 1, dans lequel la logique est de plus configurée de façon à :
détecter une entrée d'utilisateur configurée de façon à changer la condition du haut-parleur (130).

4. Procédé, **caractérisé par** :
la détection d'une pression physique exercée sur la surface d'un dispositif de communication (100) à proximité d'un haut-parleur (130) dans le dispositif de communication (100) durant une session de communication ;
la détermination du fait qu'une partie d'une réponse en fréquence pour le haut-parleur (130) se trouve ou non à l'intérieur d'une limite déterminée, en fonction de la pression physique détectée ;
la récupération d'un signal d'égalisation à partir d'une mémoire en réponse à la détermination ; et
l'application du signal d'égalisation à des signaux entrés sur le haut-parleur (130) de façon à modifier la partie de la réponse en fréquence lorsque la partie de la réponse en fréquence se trouve à l'extérieur de la limite déterminée.

5. Procédé selon la revendication 4, dans lequel la détermination comprend de plus :
la détermination du fait qu'une amplitude pour la partie de la réponse en fréquence se trouve à l'intérieur ou à l'extérieur de la limite déterminée.

6. Procédé selon la revendication 4, dans lequel la détermination comprend de plus :
la détermination du fait qu'une caractéristique spectrale de la partie de la réponse en fréquence se trouve à l'intérieur ou à l'extérieur de la limite déterminée.

7. Procédé selon la revendication 4, dans lequel la détermination comprend de plus :
l'établissement d'une limite inférieure ou d'une limite supérieure pour une bande de fréquence ;
l'association de la partie de la réponse en fréquence à une plage de fréquences au-dessus de la limite inférieure ou en dessous de la limite supérieure ; et
la détermination du fait que des fréquences à l'intérieur de la partie de la réponse en fréquence se trouvent à l'intérieur ou à l'extérieur de la limite déterminée.

8. Procédé selon la revendication 4, dans lequel la détection comprend de plus :
la détection d'une information concernant une relation entre un utilisateur et le dispositif de communication (100).

9. Procédé selon la revendication 4, dans lequel la détection comprend de plus :
la détection d'une information concernant une première relation entre un utilisateur et le dispositif de communication (100), la première relation ayant une première réponse en fréquence avec celle-ci ;
la détection d'une information concernant une deuxième relation entre l'utilisateur et le dispositif de communication (100), la deuxième relation ayant une deuxième réponse en fréquence qui diffère de la première réponse en fréquence ; et
la délivrance de l'information concernant la première relation ou la deuxième relation à la détermination ; et
dans lequel la détermination comprend de plus :
la détermination du fait que la première réponse en fréquence ou la deuxième réponse en fréquence se trouve à l'intérieur ou à l'extérieur de la limite déterminée.

10. Procédé selon la revendication 4, comprenant de plus :
le contrôle du haut-parleur (130) après l'application du signal d'égalisation afin de déterminer si la réponse en fréquence se trouve ou non à l'intérieur de la limite déterminée.

11. Support lisible par un ordinateur qui mémorise des instructions exécutables par un dispositif de traitement, le support lisible par un ordinateur comprenant :
des instructions pour détecter une pression physique exercée sur la surface d'un dispositif de communication à proximité d'un haut-parleur ;
des instructions pour déterminer quand une réponse en fréquence pour le haut-parleur se trouve à l'extérieur d'une plage préférée, en fonction de la pression physique détectée ;
des instructions pour identifier une instruction d'égalisation configurée de façon à produire une réponse en fréquence ajustée qui se trouve à l'intérieur de la plage préférée lorsqu'elle est appliquée à un signal d'entrée du haut-parleur qui est présent lorsque la réponse en fréquence se trouve à l'extérieur de la plage préférée ;
des instructions pour appliquer l'instruction d'égalisation identifiée au signal d'entrée afin de produire un signal d'entrée égalisé ; et
des instructions pour déterminer si la réponse en fréquence se trouve ou non à l'extérieur de la plage préférée lorsque le signal d'entrée égalisé est appliqué.
